(19) Europäisches Patentamt
European Patent Office
Office européen des brevets

(11) Publication number: **0 189 208 A2**

# (12) EUROPEAN PATENT APPLICATION

(21) Application number: 86100936.3

(22) Date of filing: 24.01.86

(51) Int. Cl.⁴: **H 01 L 29/08**, H 01 L 29/06, H 01 L 29/78

(30) Priority: 25.01.85 JP 11024/85

(43) Date of publication of application: 30.07.86 Bulletin 86/31

(84) Designated Contracting States: DE FR GB

(71) Applicant: **NISSAN MOTOR CO., LTD., No.2, Takara-cho, Kanagawa-ku, Yokohama-shi Kanagawa-ken 221 (JP)**

(72) Inventor: **Murakami, Koichi, 5-13-10, Iwato, Yokosuka-shi Kanagawa-ken (JP)**

(74) Representative: **Patentanwälte Grünecker, Kinkeldey, Stockmair & Partner, Maximilianstrasse 58, D-8000 München 22 (DE)**

## (54) Mos transistor with higher withstand voltage.

(57) An improved lateral MOS transistor with higher withstand voltage is shown. The transistor is provided with a drift region (19) formed so as to surround a drain region (7) thereof. The curved sections (7b) of the drain region (7) are joined with the drift region (19) whose impurity density is chosen lower than that of the drain region (19).

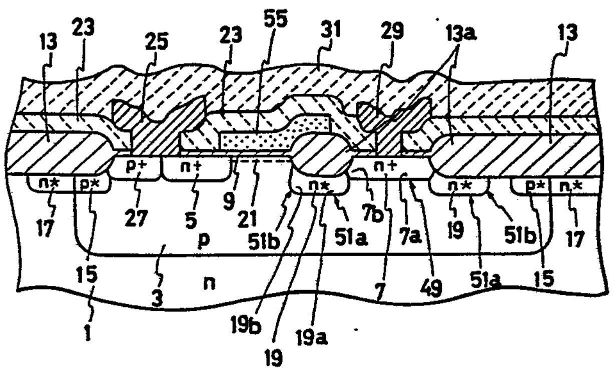


EP 0 189 208 A2

## TITLE OF THE INVENTION

MOS TRANSISTOR WITH HIGHER WITHSTAND VOLTAGE

## BACKGROUND OF THE INVENTION

The present invention relates to a lateral type MOS transistor with high withstand voltage.

A lateral MOS transistor comprises a source region, a channel region and a drain region, arranged respectively in the top portion of a semiconductor substrate. In the device current flows on the channel region between the source and drain regions which are naturally formed with curved portions where breakdown is likely to occur with somewhat low breakdown voltage. Prior to the invention some attempts have been carried out in order to obtain high breakdown voltage. However they are to bring additional processes to an ordinary fabricating process.

## SUMMARY OF THE INVENTION

An object of the invention is to provide a MOS transistor with high withstand voltage.

Another object of the invention is to provide a MOS transistor with high withstand voltage which can be fabricated by process for an ordinary MOS transistor, without additional process for increasing the withstand voltage.

Briefly described, these and other advantages and objects are accomplished by provision of a drift region around the drain region, the drift region having an impurity concentration lower than that of the drain region.

## BRIEF DESCRIPTION OF THE DRAWINGS

Fig. 1 is a cross-sectional structure digram for an ordinary MOS transistor,

Fig. 2 is a cross-sectional structure diagram for an embodiment of the MOS transistor with large withstand voltage in accordance with the present invention, and

Figs. 3 (A) through 3(M) show a series of flow charts for illustrating the formation process of the MOS transistor with large withstand voaltage.

## DESCRIPTION OF THE PREFERRED EMBODIMENTS

To facilitate the understanding of the present invention, a brief reference will be made to a prior art.

An example of the cross-sectional structure of a gerneral transverse MOS transistor is illustrated in Fig. 1.

In the example which is an N channel MOS transistor formed by the CMOS process, these are formed a source region 5 and a drain region 7 in the top portion of a P well 3. When a voltage is applied to a gate electrode 11, it is arranged that there is formed a channel region 21 beneath an oxide gate film 9 to connect electrically the source region 5 and the drain region 7. Further, a thick oxide film 13 that is formed by LOCOS method on the top layer of an N substrate 1 and the P well 3 surrounds the circumference of the MOS transistor. Moreover, in order to prevent the formation of parasitic channels underneath the thick oxide film 13, there are formed a parasitic N channel stopping region 15 and a parasitic P channel stopping region 17 by increasing the surface concentrations of the P well 3 and the N substrate 1.

The withstand voltage of the MOS transistor formed in the above manner is determined by the breakdown voltage for the planar section of the $n^+$-p junction 49a between the planar section 7a of the drain region 7 and the P well 3, the curved section of the $n^+$-p junction 49b between the curved section 7b of the drain region 7 and the P well 3, or the $n^+$-P* junction section 53 between the curved section 7b of the drain region 7 and the parastitic N channel stopping region 15.

In an ordinary case, the $n^+$ inpurity concentration of the drain region 7 is less than about 1 x $10^{20}/cm^3$ and its diffusion depth is about 1 $\mu$m, the P impurity concentration of the P well 3 is less than about 1 x $10^{16}/cm^3$, and the P impurity concentration of the parasitic N channel stopping region 15 is about $2 \sim 3$ x $10^{16}/cm^3$.

Namely, the $n^+$-P junctions 49a and 49b between the drain region 7 and the P well 3 may be approximated by a step junction. At the planer section 49a, the breakdown voltage is on the order of 70V, but at the curved section 49b the breakdown voltage is on the order of 25 to 30V under the influence of an increase in the electric field intensity due to charge concentration. Further, on the gate electrode 11 side, the breakdown voltage is still a little bit lower than the above value due to the influence of the electric field of the electrode 11 and the electric field of the fixed ions and others in an oxide gate film 9. Moreover, at the $n^+$-p* juncture 53 between the curved section 7b of the drain region 7 and the parasitic N channel stopping region 15, the breakdown voltage is on the order of 20 - 25V because of the influence of the charge concentration and of the fact that the impurity concentration of the parasitic N channel stopping region 15 is higher than for the P well 3. Accordingly, the withstand voltage of a MOS transistor formed by the ordinary CMOS process is determined by the breakdown voltages at the curved section 49b or 53 of the drain juncture which is a low value of 20 - 25V, being difficult to attain a high withstand voltage.

For this reason, a method such as the one disclosed in "Integrated High and Low Voltage CMOS Technology," pp. 77 - 82 in "IEDM" published in 1982 by "Intenational Electron Device Meeting" has been adopted in the past. Namely, it attempts to obtain a high withstand voltage by placing the gate electrode away from the drain region to give an offset structure to it, and by relaxing the concentration of electric field through elimination the effect of the curved section by way of lightly doping ions in the offset section that extends from the drain region to the section directly underneath the gate electrode.

However, this existing method has a problem in that the process becomes complicated due to the necessity of adding the ion injection process for the formation of the drift region.

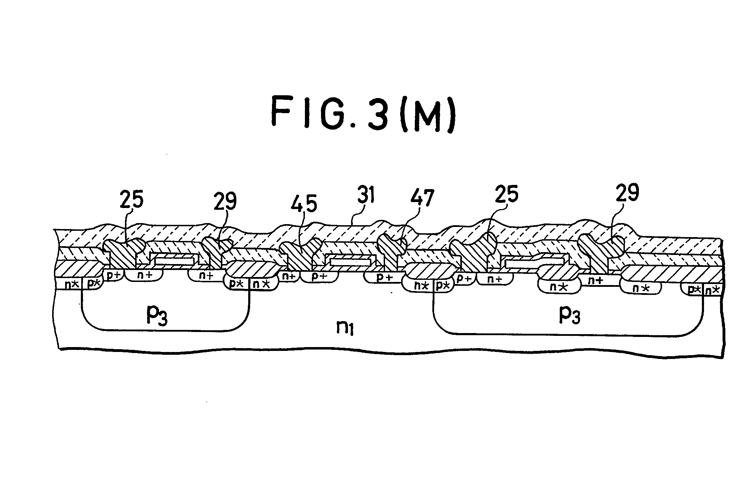

The invention will be described in what follows by referring to the Fig. 2 and 3(A) to (M).

Fig. 2 is a cross-sectional view that illustrates the structure of a MOS transistor with large withstand voltage in accordance with the present invention.

The figure shows that in the top portion of a P well 3 that is formed in an N substrate 1, there are formed a source region 5 and a drain region 7, and between the source region 5 and the drain region 7 there is formed a polysilicon gate electrode 55 on the P well 3 through a thin oxide gate film 9.

In addition, a thick oxide film 13 that is formed by LOCOS method on the top layer of the N substrate 1 and the P well 3, surrounds the circumference of the MOS transistor. The separation between the elements is designed to be accomplished by forming a parasitic N channel stopping region 15 and a parasitic P channel stopping region 17 on the bottom side of the thick oxide film 13 surrounds the circumference of the drain region 7. On the bottom side of the portion 13a of the thick oxide film 13 that surrounds the drain region 7, there is formed a drift region 19 that has a lower impurity concentration than for the drain region 7. The drift region 19 is formed so as to be joined to the curved sections 7b of the drain region 7 as well as to be connected to a channel region 21 which is situated below the oxide gate film 9. Moreover, above a portion on the gate electrode 55 side of the portion 13a of the thick oxide film 13 that surrounds the drain region 7, there is extended a portion of the gate electrode 55.

When a voltage is applied to the gate electrode 55 of this structure, there is formed a channel region 21 below the oxide gate film 9, and current flows from the drain 7 to the source region 5 via the drift region 19 and the channel region 21.

Moreover, analogous to the ordinary MOS transistor, the surface of the gate electrode 55 and the thick oxide film 13 is covered with an intermediate insulation film 23. On top of it, there is placed an aluminum-deposited source electrode 25 connected to the source region 5 and a P well contact region 27, and similarly, an aluminum-deposited drain electrode 29 is connected to the drain region 7. Furthermore, the entire exterior surface of the MOS transistor with large withstand voltage is covered with a protective passivation film 31.

Although the MOS transistor with large withstand voltage possesses a structure which is different from that of the ordinary MOS transistor, it can be shown to be formed by the identical process as is used for the ordinary MOS transistor. This will now be discribed by referring to Fig. 3.

Fig. 3(A) through 3 (M) illustrate the process flow charts for forming an ordinary N channel MOS transistor, an ordinary P channel MOS transistor, and an N channel MOS transistor with large withstand voltage of the present embodiment, by means of the standard polysilicon gate CMOS processes.

By referring to Figs. 3(A) to 3(M), each process will be described in the following.

(A) Phosphorus ions are implanted to the entire surface of the N substrate 1 for a density of order of $10^{12}$ particles/$cm^2$ in order to adjust the threshold voltage of the P channel MOS transistor.

(B) Boron ions are implanted to the specified portions of the surface to a level below $10^{13}$ particles/$cm^2$ in order to form the P wells 3.

(C) The P wells 3 are formed by diffusing the phosphorus and boron ions that were inplanted in the above processes (A) and (B), respectively. Also, a thin oxide film 33 is formed to cover the entire surface.

(D) After an $Si_3N_4$ film 35 is grown on the oxide film 33 by CVD method, $Si_3N_4$ film is removed from the portions where the thick oxide film 13 aforementioned is to be formed.

(E) Of the portions from which $Si_3N_4$ film is removed, boron ions are implanted with masks m to the portions 15' where the parasitic N channel stopping regions 15 are to be formed in the P well 3, to the order of $10^{13}$ particles/$cm^2$ in order to increase the surface concentration.

(F) Of the portions from which $Si_3N_4$ film is removed, phosphorus ions are implanted with masks m to the portions 17' and 19' where the parasitic P channel stopping regions 17 and the drift region 19 aforementioned, respectively, are to be formed, to the order of $10^{12}$ particles/$cm^2$ in order to increase the surface concentration.

(G) The thick oxide film 13 is formed by LOCOS oxidation with the $Si_3N_4$ film as the mask. At the same time, the boron and phosphorus ions implanted in the processes (E) and (F), respectively, are diffused to form, beneath the thick oxide film 13, the parasitic N channel stopping regions 15, the parasitic P channel stopping regions 17, and the drift region 19 for the MOS transistor with large withstand voltage.

(H) After removing the $Si_3N_4$ film 35 and the underlying oxide film 33, an oxide gate film 9 is formed.

(I) After growing a polysilicon film on the oxide gate film 9 by CVD method, the gate clectrode 111 for ordinary MOS transistor and the gate electrode 11 for MOS transistor with large withstand voltage are formed by selectively removing the polysilicon film.

(J) Borons are deposited with masks m to a high concentration with $BBr_3$ or by ion implantation at the portions 27', 37', and 39' where the P well contact region 27 of N channel MOS transistor, the source region 37 and the drain region 39 of the P channel MOS transistor, respectively, are to be formed. In this connection the masks m cover the gate electrodes 11, 55 on the P wells.

(K) The portions 5', 7', and 41' where the source region 5 and the drain region 7 for the N channel MOS transistor, and the N substrate contact region 41 for the P channel MOS transistor, respectively, are to be formed, are deposited with phosphori to a high concentration by $POCl_3$ or ion implantation with masks m. In this connection the mask m covers the gate electrode 11 on the N substrate.

(L) After growing an interlayer insulating film 23 by CVD method, borons and phosphori that are deposited to a high concentration by the processes (J) and (K), respectively, are diffused to form the source region 5, the drain region 7, and the P well contact region 27 for the N channel MOS transistor, and the source region 37, the drain region 39, and the N substrate contact region 41 for the P channel MOS transistor.

(M) The source \electrode 25 and the drain electrode 29, and the source electrode 45 and the drain electrode 47, for the N channel and the P channel MOS transistors, respectively, are formed by aluminum vapor deposition and patterning. Finally, a passivation film 31 is formed.

In this way, there can be formed simultaneously, from the left to the reght of Fig. 3(M), an ordinary N channel MOS transistor, an ordinary P channel MOS transistor, and an N channel MOS transistor with large withstand voltage, without introducing any additonal new process to the ordinary CMOS processes or modifying the conditions for these processes.

The withstand voltage of the N channel MOS transistor with large withstand voltage will now be described next.

In the MOS transistor with large withstand voltage, the curved section 7b of the drain region 7 joins the drift region 19, and the planar section 7a alone of the drain region 7 joins the P well 3, as shown in Fig. 1. Consequently, the withstand voltage of the MOS transistor with large withstand voltage will be determined by the breakdown voltage of the planer section 49 of the $n^+$-p junction between the planar section 7a of the drain region 7 and the P well region 3, the planar section 51a of the

$n^*$- P junction between the planar section 19a of the drift region 19 and the P well 3, or the curved section 51b of the n*- P junction between the curved section 19b of the drift section 19 and the P well 3.

As mentioned earlier, the P impurity concentration of the P well 3 is about 1 x $10^{16}/cm^3$, and the n* impurity concentration and the diffusion depth of the drift region 19 are about 2-3 x $10^{16}/cm^3$ and 1 $\mu$m, respectively. Accordingly, the n*p junctions 51a and 51b between the drift region 19 and the P well 3 are graded junctions, and the breakdown voltages for the planar section 51a and the curved section 51b are both larger than about 70V. Further, the breakdown voltage of the planar section 49 of the $n^+$-p junction between the planar section 7a of the drain region 7 and the P well 3 is about 70V as was mentioned before.

Therefore, the withstand voltage of the MOS transistor thus obtained is about 70V. In other words, a highly voltage resistant MOS transistor with withstand voltage of 70V can be formed by the identical processes that are used for obtaining the ordinary MOS transistor with withstand voltage of twenty odd volts.

It is noted that the above description which is made in conjunction with the N channel MOS transistor will apply similarly also to the P channel MOS transistor.

WHAT IS CLAIMED IS

1. A MOS transistor comprising:

a well region (3) in a semiconductor substrate (1) of a first conductivity type having source and drain regions (5, 7) of opposite conductivity type and channel region (21) in between formed in major surface of the substrate (1);

a drift region (19) of the opposite conductivity type having a lower impurity concentration than that of the drain region (7) and surrounding the drain region (7) so as to cover the curved boundary (7b) of the drain region; and

a parasitic channel stopping region (15, 17) of the opposite conductivity type formed on the boundary of the well region (3) in the substrate (1),

the drift region (19) and the stopping region (15, 17) being simultaneously formed by the same process.

2. A MOS transistor of claim 1, wherein the drift and stopping regions (19, 15, 17) are formed under thick oxide films (13, 13a).

3. A MOS transistor of claim 2, wherein the drift region (19) has a higher impurity concentration than that of the well region (3).

4. A MOS transistor of claim 3, wherein the impurity concentrations of the drift and well regions (3, 19) are in the same order.

5. A MOS transistor of claim 4 applied for CMOS.

FIG. 1

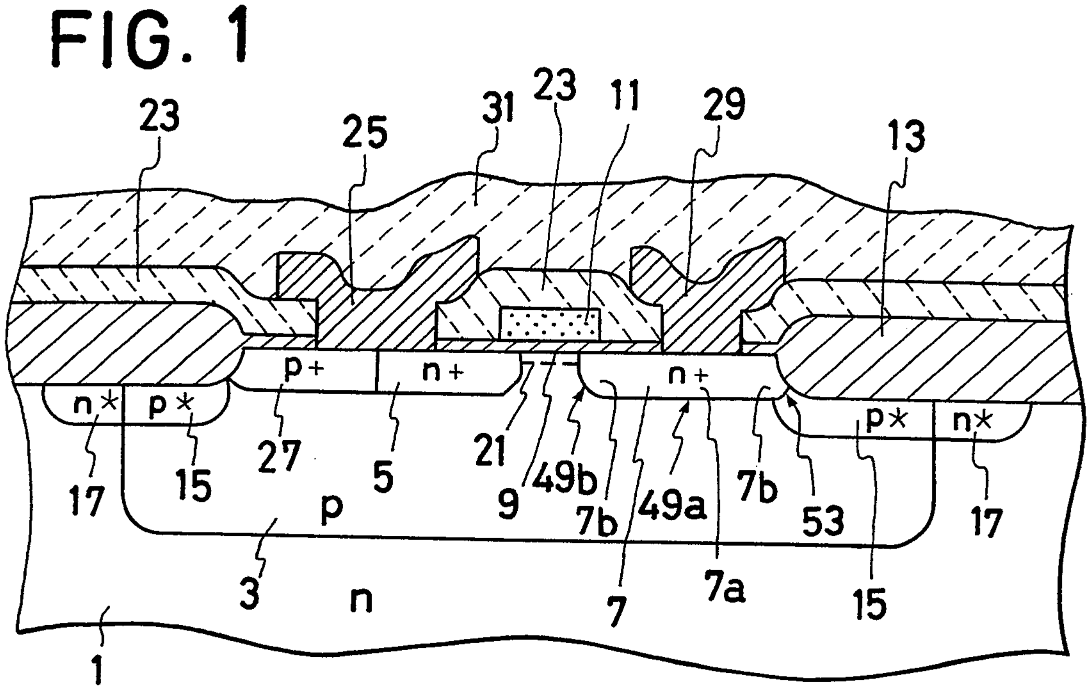
23
25
31
23
11
29
13
p+
n+
n+
n*
p*
p*
n*
27
5
21
9
49b
7b
49a
7b
53
17
15
p
17
3
n
7
7a
15
1

FIG. 2

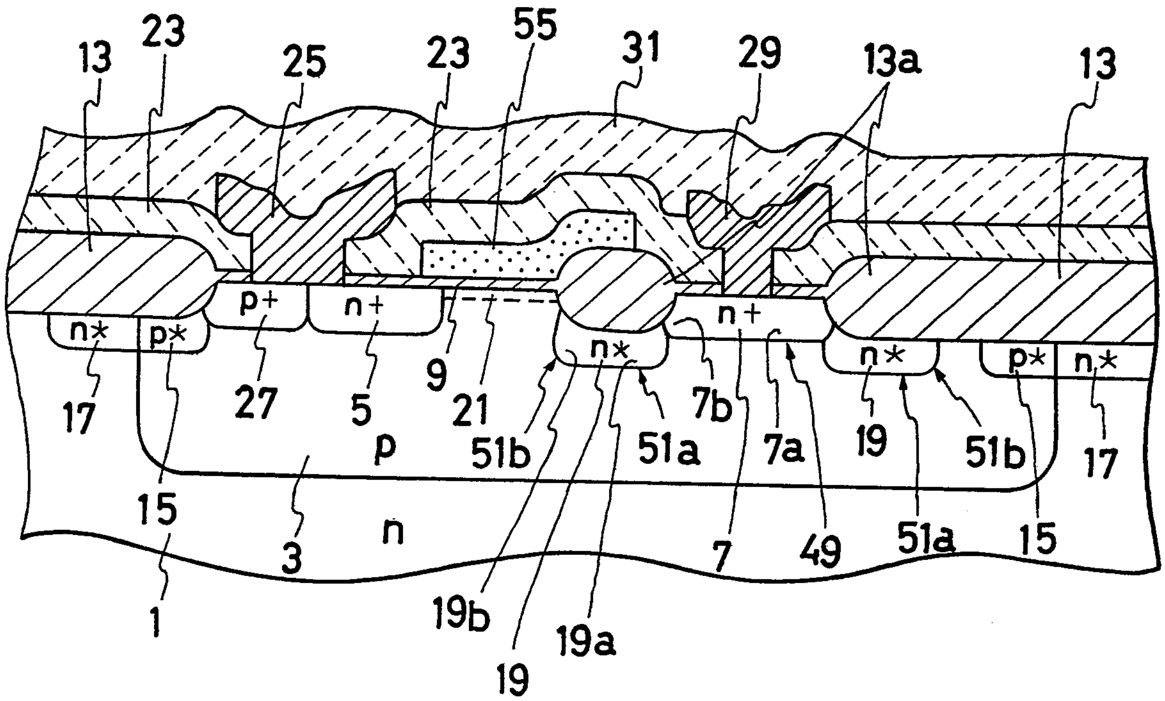
13
23
25
23
55
31
29
13a
13
p+
n+
n+
n*
p*
n*
n*
p*
n*
17
27
5
9
21
51b
7b
51a
7a
19
51b
17
p
15
3
n
7
49
51a
15
1
19b
19
19a
19

FIG. 3(A)

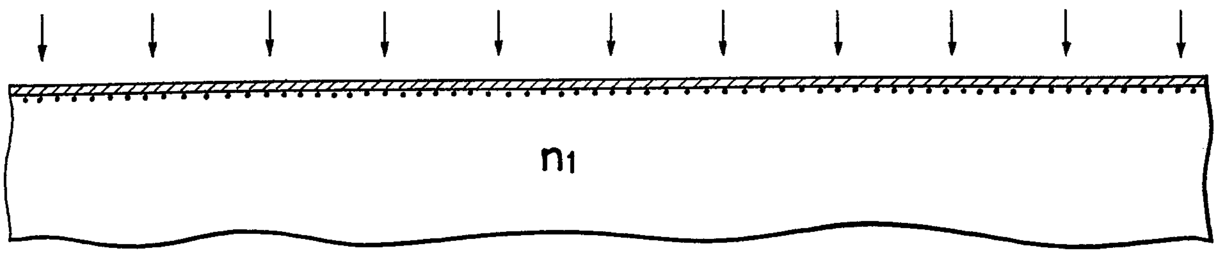


FIG. 3(B)

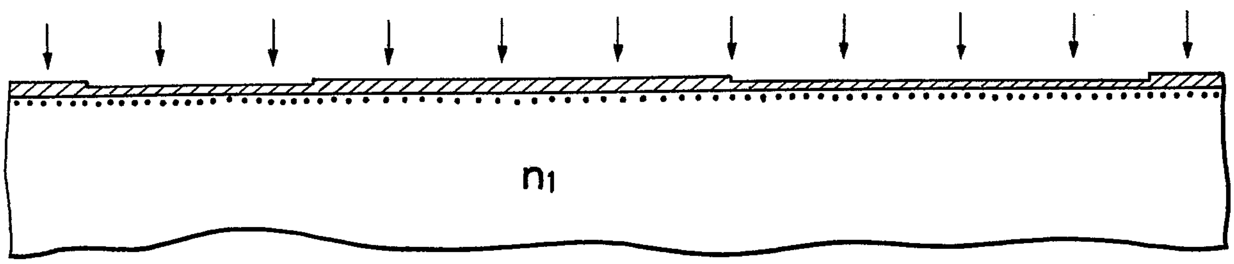


FIG. 3(C)

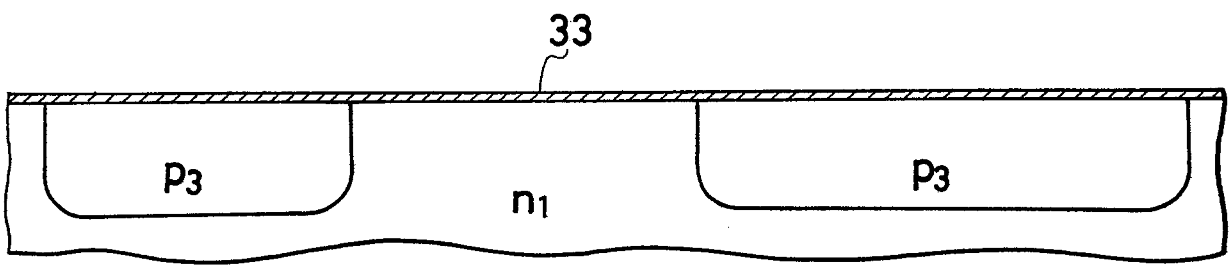


FIG. 3(D)

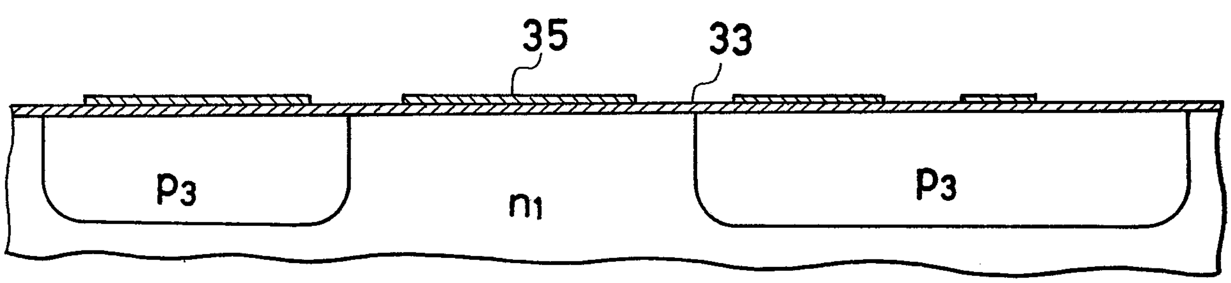

FIG. 3(E)

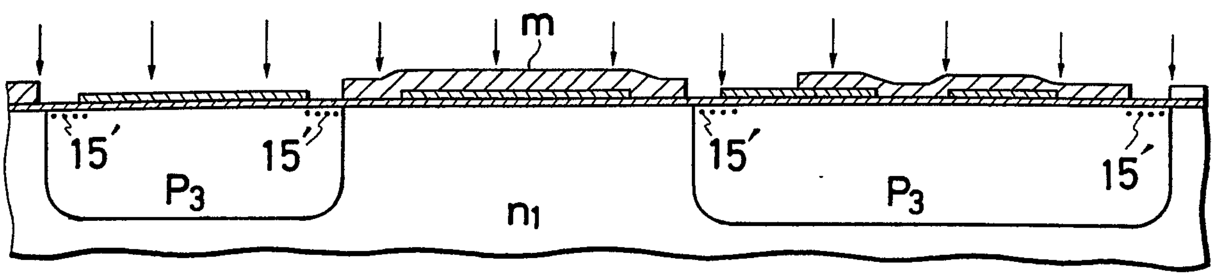


FIG. 3(F)

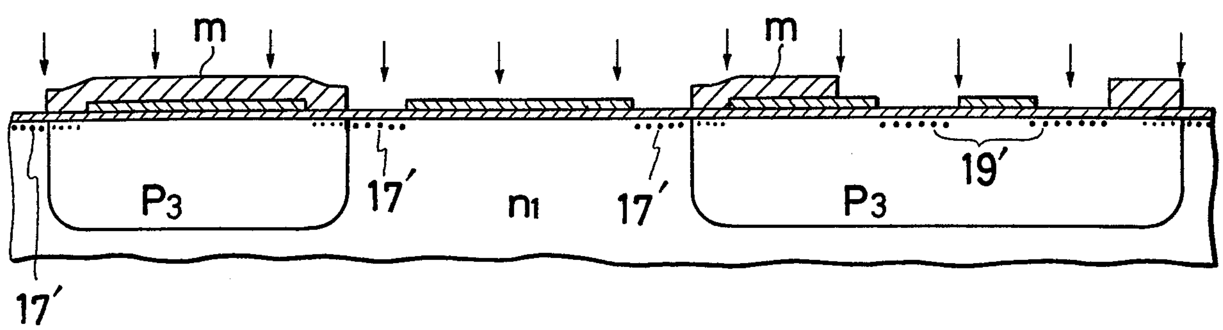


FIG. 3(G)

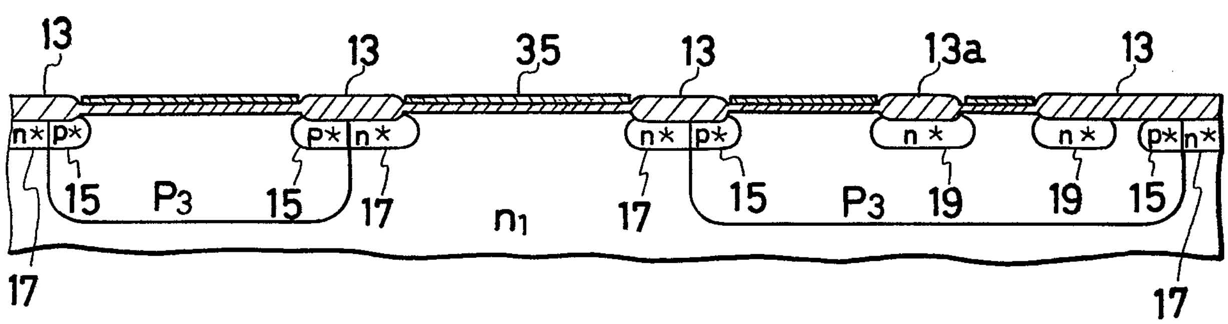


FIG. 3(H)

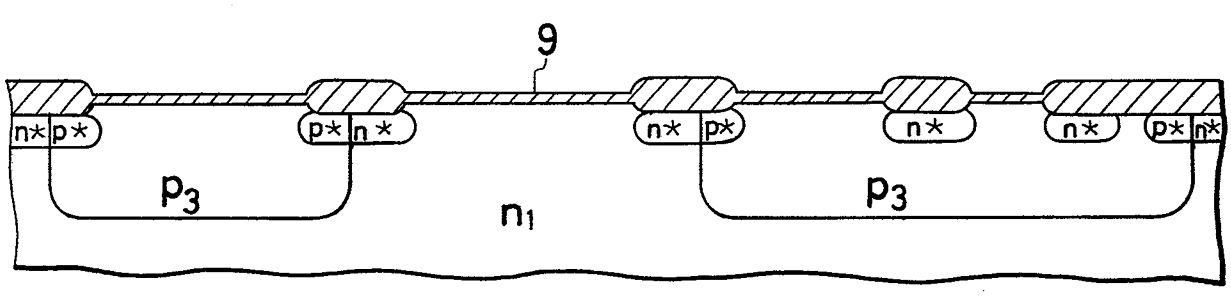

FIG.3(I)

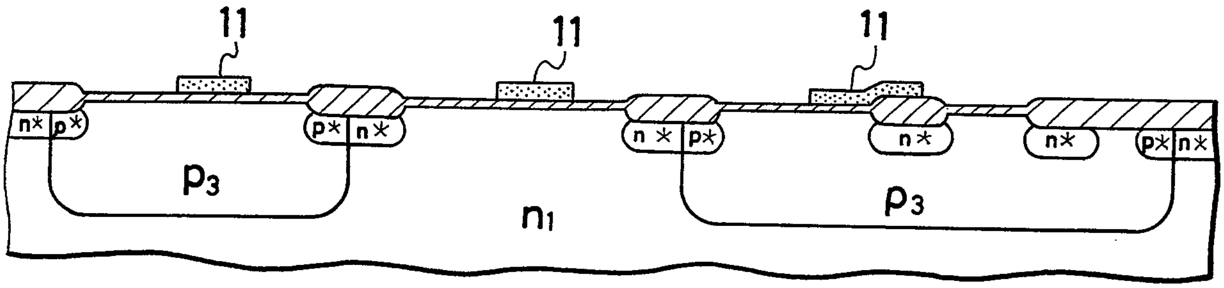


FIG.3(J)

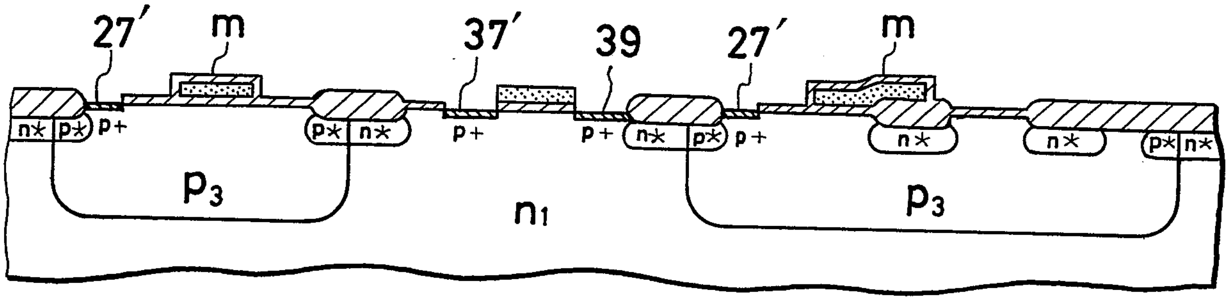


FIG.3(K)

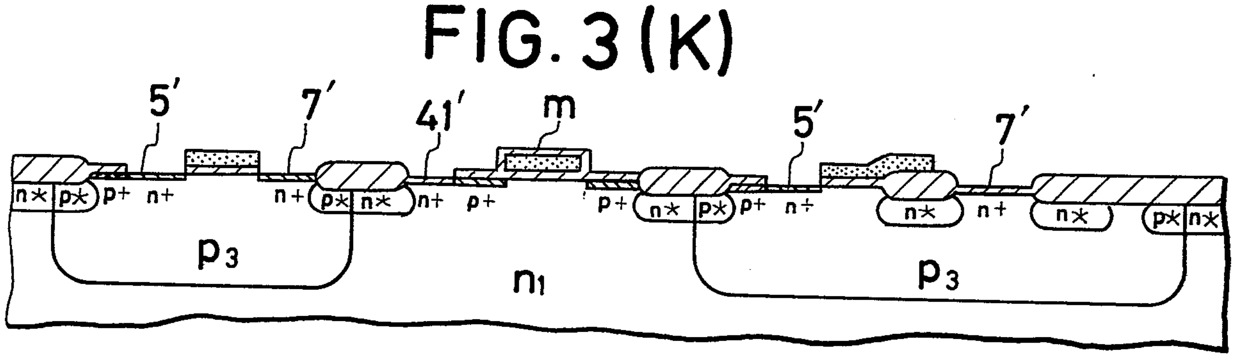


FIG.3(L)

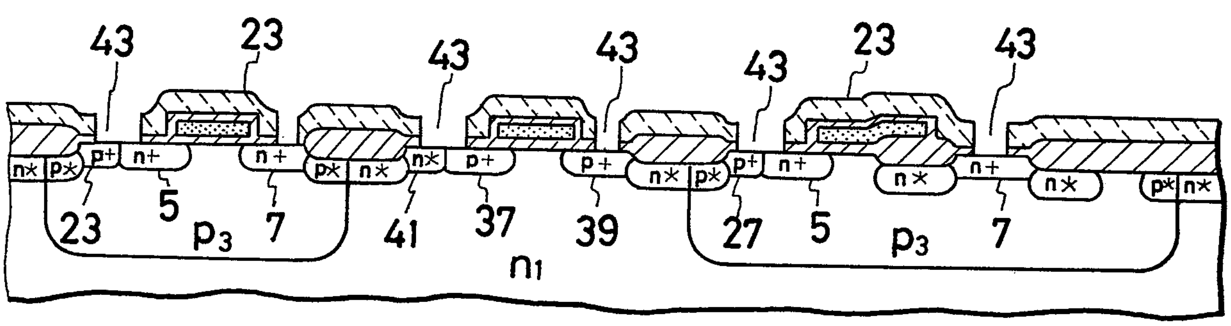

FIG. 3(M)